# EUROPEAN PATENT APPLICATION

(11) **EP 3 034 548 A1**
(43) Date of publication of application: **22.06.2016**
(21) Application number: 14198720.6
(22) Date of filing: 18.12.2014
(51) Int. Cl.: C08J 7/04, H01L 51/52, B32B 27/08

(54) **Barrier film laminate comprising submicron getter particles and electronic device comprising such a laminate**

(71) Applicant: Nederlandse Organisatie voor toegepast- natuurwetenschappelijk onderzoek TNO, 2595 DA 's-Gravenhage (NL); Rolic AG, 6300 Zug (CH)
(72) Inventor: Frantz, Richard, 68128 Village Neuf (FR); van Mol, Antonius Maria Bernardus, 2595 DA 's-Gravenhage (NL); Sailer, Bernhard, 68220 Ranspach-le-Haut (FR)
(74) Representative: V.O.

(57) **Abstract**

A barrier film laminate (1) comprising an organic layer (4) that is situated in between two inorganic layers (2,3). The organic layer comprises submicron getter particles (5) at an amount between 0.01 and 0.9% by weight. The barrier film laminate can be used for encapsulating organic electronic devices such as OLEDs. The long term homogenous transparency makes this laminate in particular suited for protecting the light emitting side of an OLED.

## Description

The present invention relates to a barrier film laminate. More in particular, the invention relates to a barrier film laminate comprising a first inorganic layer, a second inorganic layer and a first organic layer comprising submicron getter particles, which organic layer is situated in between the first and the second inorganic layer.

The invention also relates to an encapsulated organic electronic device comprising such a barrier film laminate.

### State of the art

An obstacle for the commercial exploitation of organic electronic devices such as organic light emitting diodes (OLEDs) for example for use in displays, organic photovoltaic cells (OPVs), and organic thin film transistors (OTFTs), is the deterioration of such devices under normal environmental conditions. In particular the exposure to oxygen and moisture contribute to a decline of the functional properties on a time-scale that is not acceptable for potential users of such devices. The relative fast deterioration of organic electronic devices is a hurdle that has to be taken for a successful introduction of such devices on the market, despite the advantages that such devices have compared to silicon based electronics. To slow down the deterioration of the devices, the devices are encapsulated by a material that is a good barrier against vapours and gasses, in particular against moisture and oxygen.

Devices on a non-flexible substrate can be encapsulated by for example a metallic cap. A disadvantage of a metallic cap is that it is neither flexible nor optically transparent. So, the applications of such an encapsulation are limited. For the encapsulation of flexible devices, barrier laminates, for example stacks of at least two layers, are applied. Such laminates are disclosed in for example international patent application WO 01/81649. A first layer is made of an inorganic barrier material such as a metal oxide. A second layer of the barrier laminate is made of an organic material, usually a polymer. Often it is preferred to have a stack of several alternating layers of organic and inorganic material as disclosed in patent application US 2009/0098400.

Many inorganic materials are considered to be perfect barriers against moisture and oxygen. It is, however, in general recognised that such ideal materials do not provide a perfect barrier in practise. International patent application WO03/005461 discloses that even layers of perfect barrier materials have small holes and other imperfections that allow the diffusion of vapours and gasses through such otherwise perfect barriers.

State of the art barrier laminates comprise one or more organic layers and one or more inorganic layers. To improve the performance of barrier film laminates, a getter material absorbing water entering the laminate may be incorporated. Such getter materials can be incorporated as a continuous layer as disclosed in international patent application WO2006/082111. An alternative solution to mitigate the effect of water vapour entering such laminates is to disperse getter material in the organic layer or layers. International patent application WO2012/057618 discloses such a multilayer protective barrier in which the organic layer comprises submicron getter particles.

State of the art flexible OLEDs and OPVs suffer from the lack of thin film barrier and encapsulation technology of sufficient high quality to guarantee end-user defined product life times. More in particular they suffer from the lack of transparent barriers that provide a good barrier at the light emitting side of the OLED or the side of the OPV receiving the sunlight.

### Summary of the invention

Deterioration of an organic electronic device means a decline of the functional properties of the device. The intensity of the light emitted by an OLED may be reduced or the distribution of the light intensity along the emitting surface may become nonhomogeneous. In particular, black spots may appear in the OLED due to local degradation of an electrode, for example by oxidation of the cathode. In particular because common low work-function metals, such as calcium or barium, are used which are not stable under the influence of air and moisture. A deterioration of an OLED may result in a change in the IV characteristics of the OLED due to for example physical or chemical changes at interfaces between different layers of the device. In particular oxidation that occurs at interfaces within a device is a well-recognised origin of deterioration. The decline of the functional properties may finally result in a complete loss of any functionality, in which situation the OLED does emit no light anymore. In organic transistors, the deterioration may be manifested in a decreased current output and/or a suppressed mobility of the charge carriers resulting in a reduced charge transport in the transistor. A well-known origin for the degradation of such organic electronic devices is oxidation of electrodes and the trapping of charge carriers. Deterioration of organic photovoltaic cells results in a reduced light-to-power conversion efficiency.

To avoid the diffusion of water vapour to the electrodes of for example OLEDs, a barrier film laminate comprising a stack of an organic layer sandwiched between two inorganic layers can be applied. Further improvement to acceptable lifetimes can be realised by dispersing getter particles in the organic layer, which getter particles absorb incoming water at least partly. A problem of such barrier films is, however, that the optical appearance of the transparent layer changes as a result of the water absorption. It is believed, although the inventors do not want to be bound to any theory, that this problem is caused by a change of the refractive index of the getter particles by absorption of water. Due to such an effect the difference between the refractive index of the getter particles and the organic matrix material enclosing the getter particles changes during the lifetime of the barrier, more in particular due to water absorption. When reference is made to getter particles or getter material, particles or materials are meant that are suitable for absorbing water.

To protect light emitting devices such as OLEDs against degradation of an electrode or other deteriorating effects of the environment on the device, the light emitting side of such device is protected by a barrier that need to be transparent. The optical properties, such as the transparency and the colour of the barrier may change during the lifetime of the device. In case that the barrier film comprises a transparent organic layer in which getter particles are dispersed, an initially homogeneous barrier film may become nonhomogeneous due to water uptake in the organic layer, more in particular due to water absorption by the getter particles.

It is an objective of the present invention to overcome the above mentioned problems of the state of the art in encapsulation of organic electronic devices. In particular it is an objective to provide a barrier film laminate that is a good moisture barrier.

This objective is obtained by a barrier film laminate comprising a first inorganic layer, a second inorganic layer, and a first organic layer comprising submicron getter particles, the organic layer being situated in between the first and the second inorganic layer, characterised in that the amount of submicron getter particles in the organic layer is between 0.01 and 0.9 % by weight of the organic layer. The first organic layer may be the first and only organic layer of the barrier film laminate. The first organic layer may also be the first of two or more organic layers of the laminate.

The word film is used here for a product having a sheet like geometry. One dimension of a film, the thickness, is much smaller, typically at least an order of magnitude, than the dimensions in any of the other two directions. A film laminate is a stack of at least two films adhering to each other and thus forming a coherent product that itself usually is also a film.

The surprising effect of a submicron getter particle amount that lies between 0.01 and 0.9 wt% is that this amount still provides a sufficient barrier for water vapour during a time period that corresponds to the life time of an organic electronic device, although this amount is less than 1 wt%.

In a preferred embodiment of the invention the first inorganic layer, the second inorganic layer, and the first organic layer are all optically transparent. An advantage of transparent layers is that a transparent barrier laminate can be used as a barrier at the side of an organic electronic device that need to be transparent in order to function properly. So, in particular the light emitting side of an OLED or the side of an OPV that receives the sunlight that has to be transferred into electrical energy. The surprising effect is that the optical transmission of the transparent barrier film laminate comprising an amount of submicron getter particles between 0.01 and 0.9 wt% in the organic layer does not change noticeable during a time period that matches the lifetime of electronic products, in particular light emitting diodes, based on or comprising such a laminate. So, such an optical laminate provides a barrier that has stable optical properties. More in particular such a laminate provides a transparent barrier having an appearance and transparency that remain homogenous during a long time.

The term optical transparent or just the word transparent in relation to layers or laminates is used here to refer to a property of such layers or laminates that allows light, in particular the visible part of the electromagnetic spectrum, passing through the layers or laminates. So, here transparent does not only refer to the property that allows a human being to look through such a layer or laminate to see what is behind, but it also refers to translucent layers and laminates that obscure the view, for example caused by scattering of the light.

In an embodiment of the invention, the barrier film laminate comprises a second organic layer that does not comprise a getter. Such a second organic layer may be an intermediate layer situated between the environment and one of the inorganic layers. Such a layer may have different functions. It may protect the inorganic layer against damage, for example mechanical damage. The second organic layer may also be a planarization layer between a substrate and an inorganic layer. The second organic layer may also be situated between an organic layer comprising submicron getter particles and an inorganic layer, for example to provide a proper interface.

In an embodiment of the invention, the barrier film laminate comprises a third inorganic layer and a second organic layer comprising submicron getter particles at an amount between 0.01 and 0.9% by weight of the second organic layer. In a preferred embodiment the third inorganic layer and the second organic layer are transparent. The second organic layer is situated in between the first inorganic layer and the third inorganic layer such that the barrier film laminate comprises an alternating stack of organic and inorganic layers. An advantage of this laminate is that improved barrier properties are obtained or that the individual layers need not to be of such a high quality as in case of a laminate comprising a single organic layer while providing the same barrier properties. The density of pinholes or other imperfections in the inorganic layers may for example be higher or the amount of submicron getter particles in one or both organic layers may be at the lower limit, for example between 0.01 and 0.5% by weight, or between 0.01 and 0.1% by weight, and still providing barrier properties that would otherwise only be obtainable with high quality inorganic layers or organic layers with higher amount of getter material.

In an embodiment of the invention, the number averaged particle size of the submicron getter particles in the only organic layer or in one or more of the organic layers is 200 nanometre or less. An advantage of such small getter particles is that they have a large surface area compared to their volume and therefore provide an effective water absorption. When such small particles are homogenously dispersed in the organic layer and not clustering to larger conglomerates, they are not visible. Another advantage of small getter particles is that the organic layer need not to be thick in order to encapsulate the getter particles.

In an embodiment of the invention the submicron getter particles comprise calcium oxide, magnesium oxide, barium oxide, or strontium oxide. These metal oxides absorb water well. Preferably one of the first two metal oxides is used, more preferably calcium oxide is used as a getter.

In an embodiment of the invention the submicron getter particles are embedded in a radiation cured organic material. An advantage of radiation curing is that this allows a fast solidification of the material surrounding the getter particles and thus a fast consolidation of the particles in the organic layer.

It is another objective of the present invention to provide an encapsulated organic electronic device having a long-term stability and good performance. This objective is obtained by an encapsulated organic electronic device comprising a barrier film laminate as described above. The effect of applying this barrier film laminate is that the permeation of moisture into the device will be slowed down significantly. Consequently, the deterioration of the electronic device will be delayed so that it will have a good performance during an acceptable term.

In an embodiment of the invention the bare electronic device is situated in between a substrate and a barrier film laminate according to the invention. An advantage of such an embodiment is that, in particular for non-symmetric devices, both the substrate and the barrier can be optimized for use at the respective sides of the electronic device. For example optimization of the transparency at one side of an OLED.

The present invention will further be explained below with reference to exemplary embodiments illustrated in the accompanying drawings, in which:
- Fig. 1: schematically shows a barrier film laminate with a single organic layer;
- Fig. 2: schematically shows a barrier film laminate with two organic layers;
- Fig. 3: schematically shows a barrier film laminate comprising a substrate and a topcoat;
- Fig. 4: schematically shows an encapsulated organic electronic device;
- Fig. 5: schematically shows an encapsulated organic electronic device, the device being situated between a substrate and the barrier film laminate;
- Fig. 6: schematically shows an encapsulated organic electronic device, the barrier film laminate being situated between a substrate and the device;
- Fig. 7: schematically shows an OLED;

### Detailed description of the invention

A barrier film laminate can be applied to encapsulate an organic electronic device in order to reduce the amount of water entering the device. To obtain good barrier properties, the barrier film laminate comprises two inorganic layers, one inorganic layer at each side of an organic layer that is thus sandwiched between the inorganic layers. The inorganic layers provide an intrinsic high barrier property whereas the organic layer is helpful in planarizing, viz. mitigating roughness and a possible presence of particles. The organic layer comprises an organic matrix embedding the submicron getter particles. The matrix may be any suitable organic material, including those based on thermoset or thermoplastic materials. The class of organic materials that may be used comprises materials such as poly-urethanes, poly-ethers, poly-acrylates, and epoxy resins. Solidification of a liquid layer can for example be performed by evaporation of a solvent or by a curing process at room temperature or at an elevated temperature. The curing process may also be based on radiation, as is the case in for example photo curable resins.

Each inorganic layer may comprise a single inorganic material or a composition of two or more inorganic materials. Examples of inorganic materials that may be applied are metal or semiconductor oxides such as aluminium oxide and indium tin oxide, metal or semiconductor nitrides such as boron nitride and silicon nitride, or metal or semiconductor oxynitrides such as aluminium oxynitride or silicon oxynitride. Preferred are inorganic layers comprising SiₓO_{y}, SiₓN_{y} or AlₓO_{y}. In particular silicon nitrides (SiₓN_{y}) are preferred. The compositions may be stoichiometric or not. The two inorganic layers may be made of the same material or the same composition or they may be made of different materials or different compositions.

The barrier properties of the inorganic layers are not only determined by the type of material but also by the thickness of the layers and by imperfections, in particular pinholes in the layers. The pinholes may be intrinsic to the network or, for example, created around particles. The two inorganic layers may have the same thickness or the layers may have a different thickness. The thickness of the inorganic layers in a barrier film laminate lies typically between 1 nm and 1000 nm, more in particular between 10 nm and 500 nm. For SiₓN_{y} layers a thickness between 20 nm and 300 nm may be preferred, more in particular between 50 nm and 250 nm. The inventors have observed that in particular SiₓN_{y} layers of about 150 nm thickness are a good compromise between partly incompatible demands related to optical transparency, mechanical flexibility, and barrier properties.

Inorganic barrier materials such as SiₓN_{y} have in general good intrinsic barrier properties which makes them in particular suitable for protecting organic electronic devices against moisture and oxygen. A good barrier means that the transmission of vapours and gasses that have a deteriorating effect on organic electronic devices is hindered significantly. Layers of such barrier materials as fabricated in practise are, however, not perfect. The layers usually contain pinholes. Pinholes are small imperfections, in particular small holes. The origin of such small holes may be the presence of small impurities such as dust and particles originating from abrasion of mechanical parts of the processing equipment or from mechanical treatment of the foils and films being processed. The impurities trapped in the layer may be solid, liquid, or gaseous. The origin may also be other imperfections during the growth or the deposition of the layer. In crystalline materials or semi crystalline materials, pinholes may be imperfections in the crystal structure of the material.

The layers of the barrier film laminate can be obtained by any suitable method for making or depositing such layers. Such methods include but are not limited to methods in which a precursor material is deposited and from which precursor the required barrier material is obtained for example by a heat treatment or exposure to electromagnetic radiation such as ultraviolet light (UV). Suitable techniques for making or depositing the inorganic layers include physical vapour deposition (PVD) and chemical vapour deposition (CVD). Plasma-enhanced CVD (PECVD) is considered to be in particular suitable for depositing the inorganic materials of the inorganic layer of barrier film laminates because this technique allows deposition of materials at relative low temperatures which makes this deposition technique compatible with the use of organic materials in the barrier film laminate and organic electronic devices. Suitable techniques for making or depositing organic layers include printing and coating. Out of the different printing techniques, inkjet printing may be chosen because it is particularly suited for making patterned structures from the materials used for making organic electronic devices. A preferred coating technique is slot-die coating. It will be appreciated that not all materials can be obtained and deposited by any of the techniques mentioned. Those skilled in the art know how to select the proper technique, whether mentioned above or not.

The inorganic layers or only one of the inorganic layers may be patterned or not. Patterning means here that the thickness of a layer need not to be the same over the whole area of the barrier film laminate. A layer may be patterned to allow for example bending of the laminate at a predetermined position. Patterning may also be used to allow the transmission of vapours or gasses at a certain position in for example a barrier film laminate for a sensor application.

The term "barrier film laminate" refers to a laminate that functions as a barrier against environmental influences such as moisture. The barrier film laminate according to the invention is in particular a good barrier against moisture. This laminate may, however, also be a good barrier against detrimental vapours and gasses such as oxygen. The word "film" refers to the fact that the laminate is thin in comparison to the other dimensions of the laminate. The film laminate may be a free standing laminate or a laminate that is deposited on a carrier such as a substrate or a device, for example an organic electronic device. Typically, the area of a barrier film laminate is in the range from a few square millimetres or a few square centimetres for encapsulation of single devices up to even tens or hundreds of square metres for a laminate on a roll for roll-to-roll application. The thickness of the barrier film laminates, in particular flexible laminates will be in general not be larger than 1 mm when it comprises a carrier substrate. Typically, the thickness of a laminate comprising a substrate may be 500 µm or thinner. Barrier film laminates without a substrate typically will be thinner than 100 micrometres, more in particular thinner than 50 µm. The barrier film laminate may even be thinner than 10 µm.

A substrate may be made out of a single material or composition but it may also be a laminate of different materials. The substrate may for example be covered partly or completely by an organic layer at the side of the substrate where the barrier film laminate or the organic electronic device is deposited. In particular if an inorganic barrier layer is the first layer to be deposited on the substrate, such a substrate may comprise an organic surface layer, which layer may be advantageous to minimize the number of pinholes in the inorganic layer.

When reference is made to a layer that is positioned on top of another layer or on top of a substrate it is not to suggest any specific orientation with respect to the gravitational force. If a layer is on top of a substrate, the layer may be above or below the substrate. The same holds for a device and a substrate or layer.

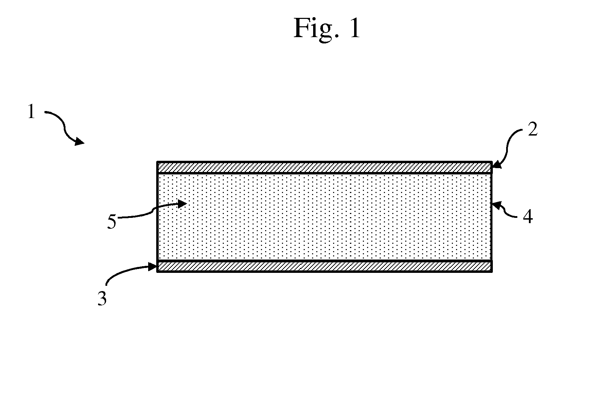

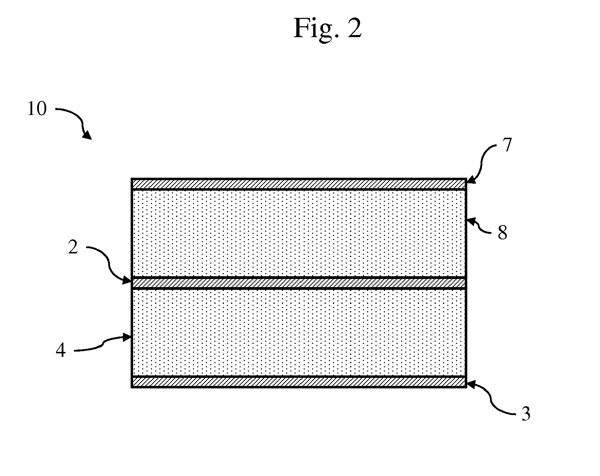

Figure 1 shows an embodiment of the barrier film laminate (1) with only one organic layer (4) comprising submicron getter particles (5). The organic layer is sandwiched between two inorganic layers (2,3). Preferably, all layers of the barrier film laminate are optically transparent. The drawing in this figure 1 and also the drawings in the figures 2 to 7 are for illustration only and the dimensions of the different layers are not drawn to scale. The ratio of the thicknesses of the individual layers as shown in the figures need not to be the actual ratio of the layers of the laminate. One of the functions of the organic layer is to create a distance between the two inorganic layers. Consequently, the organic layer creates a distance between pinholes and other defects that may be present in the upper and the lower inorganic layer. The larger the distance between pinholes and defects in the upper and lower layer, the larger the path for the diffusion of water molecules through the barrier film laminate, more in particular through the organic layer comprising getter material.

The organic layer of the barrier film laminate may comprise a radiation curable resin, viz. a resin that can be solidified by electromagnetic radiation. Examples of such resins are UV-curable resins comprising an acrylate or a methacrylate. The organic layer may also comprise a solvent-based resin such as a curable formulation dissolved in a solvent or a polymer solution that only requires a drying step. Typically, the organic layer may have a thickness between 0.1 µm and 200 µm. In order to obtain an inorganic layer with a low pinhole density it is preferred that the thickness is more than 1 µm or even more than 10 µm. To obtain a sufficient decoupling of the two inorganic layers and a good planarization of the layer to mitigate the effect of possible impurities, the thickness is preferably between 20 µm and 100 µm.

The getter material is dispersed in the organic layer as submicron particles. So, the getter particles have a typical size in the submicron range, viz. the particles are not larger than 1 µm in at least one dimension but preferably in all dimensions. Advantageous are powders with particles having an averaged diameter between 0.01 and 0.5 µm. When such particles are homogeneously dispersed in a transparent organic layer up to an amount of 0.9 by weight of the solidified organic layer, the layer remains transparent. The getter materials selected for incorporation in the laminate are hygroscopic materials, viz. materials that can absorb or otherwise bind water. Suitable getter materials are for example calcium oxide (CaO), barium oxide (BaO), magnesium oxide (MgO) or strontium oxide (SrO). In particular suitable appear to be CaO submicron particles with a number averaged size of 200 nanometre or less. Such particles can for example be obtained from Strem Chemicals (Catalog number # 20-1400) or from Sigma Aldrich (Catalog number # 634182).

The amount of getter particles required for a specific barrier laminate is determined, among others, by the required lifetime of the product for which the barrier is to be used. Typically a lifetime will be more than 1,000 hours. The inventors have for example made OLEDs encapsulated by the barrier film laminate comprising 0.1 wt% submicron getter particles, which encapsulated OLEDs were performing well after 1992 hours at 60 °C and 90 % relative humidity. The amount of getter material may for example chosen as to be sufficient to absorb the amount of water vapour that the organic layer comprises when being saturated with water in absence of getter material.

Apart from the materials mentioned above, there are many other materials which can absorb water and therefore in principle are suitable for being applied in the organic layer of the barrier laminate. Examples of such materials are oxides such as SiO₂, P₂O₅, and Al₂O₃, metal hydrides such as CaH₂, NaH, and LiAlH₄, metal salts such as CaSO₄, NaSO₄, MgSO₄, CaCO₃, K₂CO₃, and CaCl₂, zeolites, metal perchlorates such as Ba(ClO₄)₂ and Mg(ClO₄)₂.

In a further embodiment, the embodiment shown in figure 1 comprises an additional organic layer that does not comprise a getter. Preferably, this additional organic layer is optically transparent. This additional organic layer may be a protective coating on top of the first inorganic layer, providing protection against for example mechanical damage. In this embodiment the first inorganic layer is sandwiched between the first organic layer comprising submicron getter particles (2) and the protective coating. The additional organic layer may also be situated between the organic layer comprising submicron getter particles and an inorganic layer, for example to provide a proper interface between those layers. In still a further embodiment, the embodiment shown in figure 1 comprises two additional organic layers that both do not comprise a getter. One of the additional layers may be a protective coating on the first inorganic layer (2) and the second additional coating may be a protective coating on the second inorganic coating (3), thus providing protection at both sides of the embodiment of the barrier laminate shown in figure 1. For many applications it is preferred that the additional layers, more in particular all layers of the laminate are optically transparent.

An embodiment of the barrier film laminate comprises two organic layers, of which at least one comprises submicron getter particles. This embodiment will further be elucidated with reference to figure 2. The first organic layer (4) comprises submicron getter particles in an amount that is between 0.01 and 0.9 wt%. This first organic layer is sandwiched between a first (2) and a second (3) inorganic layer. The second organic layer (8) is situated on top of the first inorganic layer (2). The second organic layer may be in direct contact with the first inorganic layer as is shown in figure 2. However, there may be an intermediate layer between the second organic layer (8) and the first inorganic layer (2). The second organic layer may have the function of protecting the inorganic layer. Such a protective layer is often referred to as a topcoat and it may provide protection against for example scratches and other mechanical damage. Typically, such an organic topcoat is made out of a radiation curable material such as an acrylate, methacrylate, epoxide, oxetane or a combination of one or more of these materials. The thickness of the topcoat is typically between 1 µm and 100 µm, preferably between 10 µm and 50 µm. The second organic layer may also be a substrate, for example a foil for carrying the other layers of the laminate. A substrate will be needed if a freestanding barrier film laminate is aimed at and the laminate of the first organic layer and the two inorganic layers itself is too thin to be handled as a freestanding foil. Examples of such substrates are foils made from polypropylene (PP), polyphenylene sulphide (PPS), polyethylene naphthalate (PEN), polyether sulfone (PES), or polyethylene terephthalate (PET) foil. Typical thicknesses of such foils are between 1 µm and 500 µm or more particular between 50 µm and 250 µm.

The barrier film laminate may further comprise a third inorganic layer (7) situated on top of the second organic layer (8). This embodiment of the barrier film laminate comprising three inorganic barrier layers may be preferred if further improvement of the barrier properties is aimed at in comparison to the barrier film layer shown in figure 1. In a preferred embodiment of the barrier laminate comprising two organic layers, the second organic layer comprises submicron getter particles at an amount between 0.01 and 0.9 wt% of the second organic layer. The two organic layers may be identical in that they have the same thickness and in that they comprise the same organic material and the same getter particles. For specific applications, the amount of getter particles in the first organic layer is between 0.01 and 0.5 wt%, whereas the amount of the getter particles in the second organic layer is between 0.01 and 0.9 wt%. More in particular, the amount of getter particles in the first organic layer may be less than in the second organic layer. In a preferred embodiment all layers of the laminate and also the complete barrier film laminate are optically transparent, for example to allow light generated by an OLED passing through the barrier laminate.

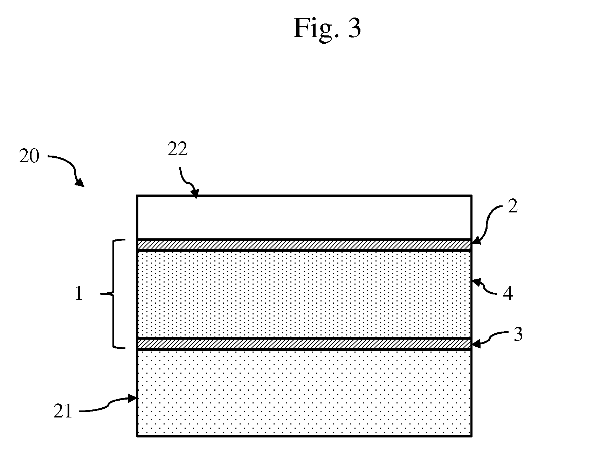

As mentioned above, the barrier film laminate may comprise a substrate. An embodiment of the laminate comprising a substrate is shown in figure 3. This embodiment is a stack comprising a substrate (21), a first inorganic layer (2), an organic layer (4) comprising submicron getter particles, and a second inorganic layer (3). The second inorganic layer is the layer that is nearest to the substrate. So, in the barrier film laminate the order is as follows: a substrate (21), an inorganic layer (3), an organic layer (4) comprising submicron getter particles, and an inorganic layer (2). The substrate may be a substrate that is coated with for example an organic planarization or adhesion layer forming an intermediate layer between the inorganic layer (3) and the bulk of the substrate. Although an organic foil is preferred as a substrate because of its flexibility, also other types of substrates can be used. The substrate may for example be a glass or ceramic substrate. The substrate may also be a metallic substrate, in particular a metallic foil. Depending on the use that is aimed at, the substrate may be optical transparent, either clear or opaque, or the substrate may be non-transparent for light. A transparent barrier laminate is in particular suited for the encapsulation of optoelectronic devices such as OLEDs because such a laminate can also be applied on the light emitting side of the OLED. The first inorganic layer (2) may be covered, either partly or completely, with a topcoat (22) to protect the stack, more in particular the upper inorganic layer, against damage.

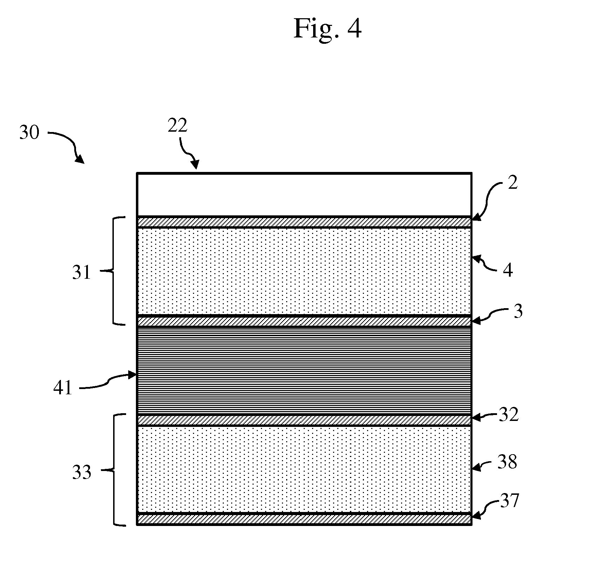

The invention also relates to an encapsulated organic electronic device comprising a barrier film laminate. An embodiment of an encapsulated electronic device (30) is shown in figure 4. Examples of organic electronic devices are organic light emitting diodes (OLEDs). organic photovoltaic cells (OPVs), organic thin film transistors (OTFTs), and organic memory devices. According to this embodiment, the bare organic electronic device (41) is encapsulated at two opposite sides by a barrier film laminate (31,33). According to the embodiment of figure 4, both barrier film laminates comprise an organic layer sandwiched between two inorganic layers. The two barrier laminates may be identical, but they may also be different in one or more aspects. The organic layers (4,38) of the two barrier film laminates may for example have different thicknesses or different compositions. Differences in material composition may for example relate to the organic material or the getter particles. Also the four inorganic layers (2,3,32,37) may be the same or may differ from eachother in one or more aspects, more in particular in thickness and material composition.

The encapsulated organic electronic device as shown in figure 4 may be supported by a substrate. In general, an organic electronic device comprises a substrate to allow the device to be handled. The substrate may be for example a glass substrate or a polymeric foil coated with a barrier, for example a barrier film laminate comprising an organic layer sandwiched between two inorganic layers.

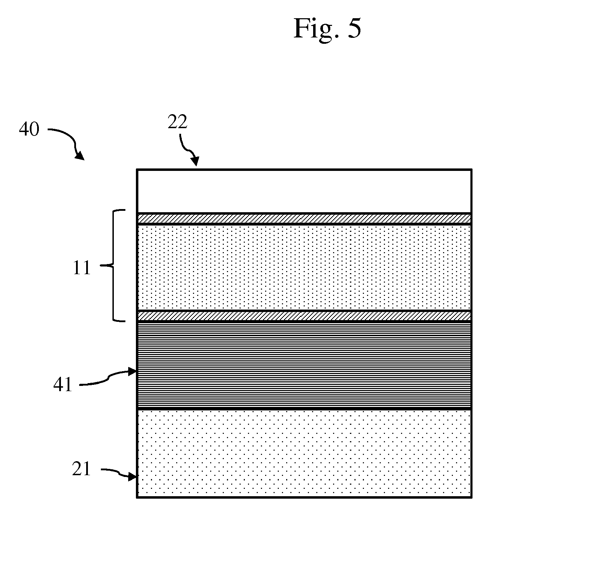

In figure 5 an embodiment of an encapsulated organic electronic device (40) is shown in which the bare organic electronic device (41) is situated in between a substrate (21) and the barrier film laminate (11). According to this embodiment of the encapsulated organic electronic device, the bare device (41) is positioned or deposited on top of a substrate (21). Often, the bare device itself comprises several layers that are subsequently deposited on the substrate. Such a bare device may be an OLED as described below. It may however also be an OPV or an OTFT. On top of the bare device, so at the side of the bare device opposite to the substrate, a barrier film laminate (11) is situated. This laminate comprises an organic layer comprising submicron getter particles. The organic layer is sandwiched between two inorganic layers. Several embodiments of the barrier film laminate can be applied, including those described above. Embodiments of the barrier film laminate shown in the figures 1 and 2 will preferably be deposited layerwise on the bare device by a suitable deposition technique, although they may also be laminated on top of the device. Barrier film laminates comprising a substrate, for example the one shown in figure 3, including a topcoat (22) may be applied by a laminating process known from lamination of foils.

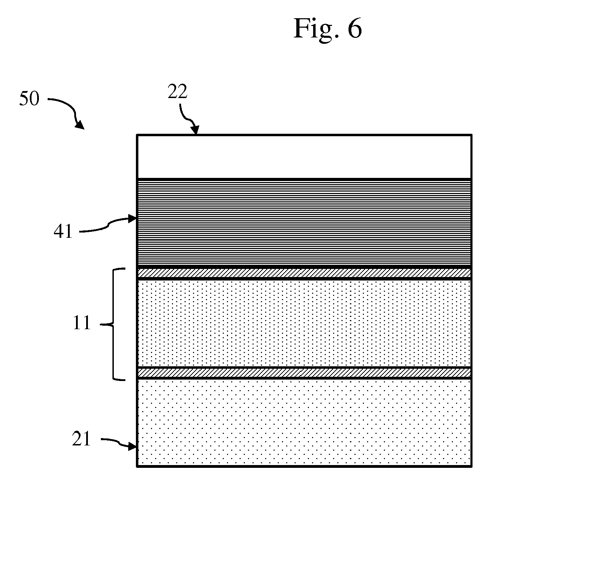

In another embodiment of the encapsulated organic electronic device (50), shown in figure 6, the barrier film laminate (11) is situated in between the substrate (21) and the organic electronic device (41). In such an embodiment, the device may be protected by a topcoat (22). The topcoat in this encapsulated device needs to have barrier properties. Layers having good barrier properties are for example glass substrates, metallic layers, and barrier film laminates as described before. In an embodiment where the top layer is a laminate as shown in figure 1, the encapsulated device is actually the one shown in figure 4, further comprising a substrate.

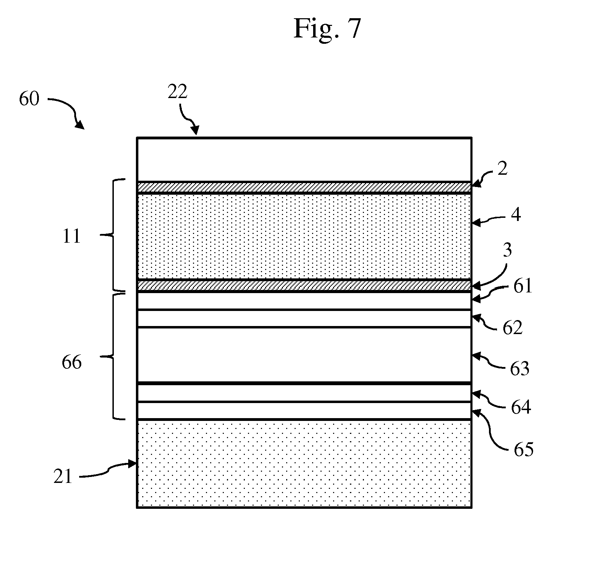

An example of an organic electronic device, more particular an encapsulated organic optoelectronic device is an OLED. The generic structure of such an OLED will be elucidated with reference to figure 7. The OLED is deposited on a substrate (21), for example a glass substrate, providing a good barrier against water vapour. The bare OLED (66) is situated on top of the glass substrate. In case that the substrate is not a good barrier against moisture, for example if the substrate is a polymeric foil, than the substrate may be covered with a barrier. Preferably, such a barrier is a barrier film laminate as shown in figure 1, viz. a barrier comprising an organic layer that is sandwiched in between two inorganic layers. The layer of the OLED that is in direct contact with the substrate is an ITO layer (65). This ITO layer and a PEDOT:PSS (64) layer deposited on the ITO, form the hole injecting anode of the OLED. Here a PEDOT:PSS layer with a thickness of 100 nm is applied. The light emitting layer (63) that is deposited on top of the PEDOT:PSS layer, here is a light emitting polymer (LEP) comprising a polyspirofluorene backbone either or not comprising hole accommodation units and/or energy transfer dyes to tune the wavelength of the emitted light. Other materials that may be used in the electroluminescent layer of an OLED are for example derivatives of poly(p-phenylene vinylene) (PPV) and polyfluorene (PF) and materials such a poly(3-hexylthiophene) (P3HT). The cathode of the OLED is deposited on top of the LEP and is a combination of two layers. A thin layer (62) of a low work-function metal is deposited in direct contact with the LEP. Here this thin layer is a 5 nm thin barium layer. In other devices other metal may be used, for example calcium. The barium layer of the OLED is covered with a second metallic layer (61), here a 100 nm thick aluminium layer.

The bare OLED, which may comprise additional layers, is covered by a barrier film laminate (11). In the device shown in figure 7, the barrier laminate is the one shown in figure 1. More in particular the organic layer is a layer of a low-VOC, solvent-less UV curable acrylic formulation comprising 0.1 weight % of the getter material CaO. The organic layer has a thickness between 10 and 100 µm, for example 40 µm. The inorganic layers (2,3) are SiₓN_{y} layers having a thickness between 100 and 200 nm, for example 150 nanometre. To protect the encapsulated device from mechanical damage, for example scratches, a 20 µm thick top coat (22), which for example may comprise a low-VOC, solvent-less radiation curable formulation optimized for scratch resistance.

Although the barrier film laminate has been developed for the encapsulation of organic electronic devices, the laminate may also be applied for encapsulation of other devices and products that are sensitive to deterioration by water vapour.

## Claims

1. Barrier film laminate (1) comprising a first inorganic layer (2), a second inorganic layer (3) and a first organic layer (4) comprising submicron getter particles (5), the organic layer being situated in between the first and the second inorganic layer **characterised in that** the amount of submicron getter particles in the organic layer is between 0.01 and 0.9% by weight of the organic layer.

2. Barrier film laminate according to claim 1, wherein the first inorganic layer, the second inorganic layer, and the first organic layer are all optically transparent.

3. Barrier film laminate according to claim 1 or 2, comprising a third inorganic layer (7) and a second organic layer (8) comprising submicron getter particles at an amount between 0.01 and 0.9% by weight of the second organic layer, wherein the second organic layer is situated in between the first inorganic layer (2) and the third inorganic layer (7) such that the barrier film laminate comprises an alternating stack of organic and inorganic layers.

4. Barrier film laminate according to claim 3, wherein the amount of submicron getter particles in the first organic layer is between 0.01 and 0.5% by weight of the first organic layer.

5. Barrier film laminate according to any of the preceding claims, wherein the number averaged particle size of the submicron getter particles in the only organic layer or in one or more of the organic layers is 200 nanometre or less.

6. Barrier film laminate according to any of the preceding claims, wherein the submicron getter particles comprise calcium oxide, barium oxide, magnesium oxide, or strontium oxide.

7. Barrier film laminate according to claim 6, wherein the submicron getter particles are embedded in a radiation cured organic material.

8. Barrier film laminate according to claim 6, comprising calcium oxide submicron getter particles.

9. Barrier film laminate (20) according to any of the preceding claims, comprising a substrate (21).

10. Barrier film laminate according to claim 9, wherein the substrate is a flexible substrate.

11. Barrier film laminate according to claim 9 or 10, wherein the substrate is optically transparent.

12. Encapsulated organic electronic device (30) comprising a bare organic electronic device (41) and a barrier film laminate (11) according to any of the claims 1 to 11.

13. Encapsulated organic electronic device (40) according to claim 12, wherein the bare organic electronic device is situated in between the substrate (21) and the barrier film laminate (11).

14. Encapsulated organic electronic device (50) according to claim 12, wherein the barrier film laminate (11) is situated in between the substrate (21) and the bare organic electronic device (41).

15. Encapsulated organic electronic device according to claim 12,13, or 14, wherein the organic electronic device comprises an organic light emitting diode.
